# EUROPEAN PATENT SPECIFICATION

(11) **EP 0 604 096 B1**
(45) Date of publication and mention of the grant of the patent: **10.04.1996**
(21) Application number: 93310049.7
(22) Date of filing: 14.12.1993
(51) Int. Cl.: C30B 31/10, C30B 25/08

(54) **Fused quartz diffusion tubes for semiconductor manufacture**
Diffusionsrohren aus geschmolzenem Quarzglas für die Herstellung von Halbleitern
Tubes à diffusion en quartz fondu pour la fabrication de semi-conducteurs

(30) Priority: 21.12.1992 US 994017
(43) Date of publication of application: 29.06.1994
(73) Proprietor: GENERAL ELECTRIC COMPANY, Schenectady, NY 12345 (US)
(72) Inventor: Dogunke, Gordon Ernest, Cleveland, Ohio 44109 (US); Scott, Curtis Edward, Mentor, Ohio 44060 (US)
(74) Representative: Pratt, Richard Wilson

(56) References cited:
- FR-A- 1 293 554
- FR-A- 1 431 666
- GB-A- 2 184 885
- US-A- 4 102 666

## Description

### BACKGROUND OF THE INVENTION

### Field of the Invention

This invention relates to a fused quartz tube or article having a layer of metal silicate resistant to sodium diffusion. More particularly, this invention relates to a fused quartz diffusion tube useful in semiconductor manufacture, wherein the surface of the quartz tube has a coating or layer resistant to sodium diffusion, said coating or layer being a glassy material comprising a silicate of at least one metal selected from the group consisting of scandium, yttrium, beryllium, rare earth metal and mixture thereof.

### Background of the Disclosure

Semiconductor grade silicon wafers used to make integrated circuits are processed at high temperatures in fused quartz tubes. The various processes employed within such fused quartz tubes include oxidation, chemical vapor deposition and various diffusion processes wherein the silicon semiconductor material is contacted with a gaseous atmosphere containing one or more doping elements. In such processes, the silicon single crystal material or wafers are heated in a fused quartz tube or vessel which is closed at both ends and the gaseous atmosphere is admitted into the vessel or tube in order to achieve thermal diffusion of the doping element into the silicon, oxidation of the silicon or a chemical vapor deposition of a suitable material onto at least a portion of the silicon. In all of these process steps it is important to avoid contamination of the silicon with materials which can change electrical properties of the silicon in a manner detrimental to semiconductor device performance. High purity fused quartz tubing is used for these processes because it is available in the required purity level and is capable of withstanding process temperatures in excess of 1200°C. However, such fused quartz is known to have a relatively open atomic structure which enables elements detrimental to semiconductors, particularly sodium which has a small atomic diameter, to diffuse through the fused quartz tube wall and contaminate the silicon articles or silicon wafers inside the fused quartz tube undergoing the processing. The source of potential sodium contamination is usually the refractory material used to make the furnaces which surrounds the fused quartz diffusion tube during the doping, etc., of the silicon inside the tube.

Sodium contamination of silicon in such processes is especially detrimental to semiconductor device performance as it changes the electrical properties. One of the current practices used by the semiconductor industry to avoid sodium contamination is to periodically purge the fused quartz tube with high temperature hydrogen chloride gas. This is believed to reduce sodium contamination of the silicon wafer. The hydrogen chloride gas purge is sometimes used in conjunction with chemical vapor deposition of a silicon nitride layer on the inside surface of the fused quartz tube, in which the silicon nitride acts as a barrier to reduce the amount of sodium contamination penetrating through the walls of the fused quartz tube during the various processes and contaminating the semiconductor wafers. However, the use of a hydrogen chloride purge presents difficulties of its own and it is desirable to reduce or minimize sodium diffusion through a fused quartz tube employed in semiconductor processing without having to use a hydrogen chloride purge or to deposit silicon nitride on the interior wall surface of the tube.

### SUMMARY OF THE INVENTION

The present invention relates to a fused quartz diffusion tube having improved resistance to sodium diffusion through its wall and the use of such tube for manufacturing silicon semiconductor material, wherein said fused quartz diffusion tube has a metal silicate coating layer or zone comprising a silicate of at least one metal selected from the group consisting of scandium, yttrium, beryllium, rare earth metal and mixture thereof. This coating or zone is glassy in nature and is obtained by fusing or melting the desired metal silicate or oxide or precursor thereof onto and into the surface of the quartz diffusion tube. At least a portion of some of the metal ions present therein diffuses into the silica surface of the diffusion tube to form a zone or layer containing the metal ions in the silica lattice near or in the vicinity of the surface. The fused quartz diffusion tube may be coated on the outside surface, on the inside surface or on both the inside and outside surfaces with the glassy coating or layer according to the invention. In many cases it will be preferred that the coating be only on the exterior surface of the diffusion tube to avoid contamination of the silicon in the tube with metal ions from the coating.

In the use of a diffusion tube having a sodium diffusion-resistant coating on its surface according to the present invention, semiconductor grade silicon material is placed in a fused quartz diffusion tube having a coating, layer or zone according to the invention. With the tube closed at both ends, the appropriate gaseous atmosphere is introduced into the tube wherein it contacts the silicon metal at the desired elevated temperature. The gas and silicon-containing tube is then heated to the appropriate temperature for the doping, oxidation or deposition process to occur, whichever is selected by the practitioner.

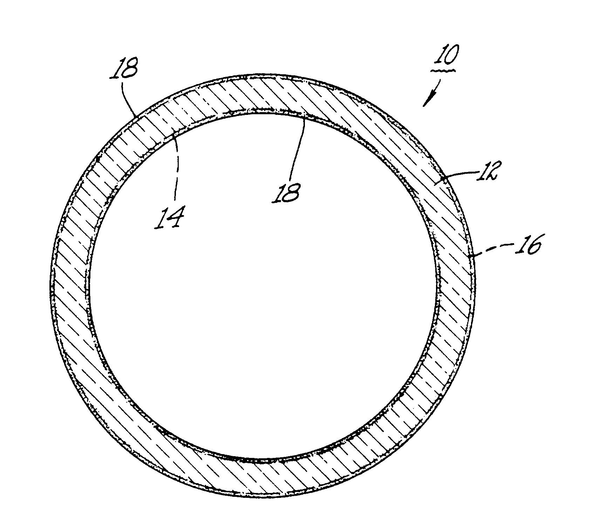

### BRIEF DESCRIPTION OF THE DRAWING

The Figure illustrates an end view of a fused quartz diffusion tube having a coating on both the inside and outside surfaces according to the invention, shown in greatly exaggerated scale.

### DETAILED DESCRIPTION

Referring to the Figure, diffusion tube 10 according to the invention comprises fused quartz tube 12 having coating 18 applied to its outer 16 and inner 14 surfaces, respectively, said coatings being a coating according to the present invention. Fused quartz tube 12 is made of vitreous silica having an SiO₂ content of at least 99 wt. % and is commonly made by fusing naturally occurring high purity silica sand having an SiO₂ content greater than 99% and preferably at least 99.9 wt. %. The silica sand is chemically treated to remove impurities prior to its being fabricated into a fused quartz diffusion tube. However, uncrystallized or crystallized synthetic quartz or silica having a purity of greater than 99 wt. % SiO₂ can also be used, such as that formed by the pyrolysis of a silica precursor (such as a mixture of silicon tetrachloride and water) as is known to those skilled in the art. Although the fused quartz tube 12 is shown in the Figure as having a coating 18 according to the invention on both the inside 14 and outside 16 surfaces, a coating according to the invention may be disposed only on the inside surface or only on the outside surface. Further, although the coating may be identical on both surfaces, it may also have different compositions on the outer and inner surfaces, as long as the composition thereof falls within the scope of the coating composition of the invention, the choice being left to the practitioner. However, as set forth above, in most cases the coating will be only on the outside surface of the diffusion tube because the metal in the metal silicate coating of the invention may, of itself react with the gaseous atmosphere inside the diffusion tube and/or contaminate the silicon therein. Further, since the source of potential sodium contamination is from outside the diffusion tube, it follows that the presence of the metal silicate coating will be most efficacious on the outside surface of the tube. In the Figure, a sharp boundary line between the surface(s) of the tube and coating(s) is not shown, because the metal ions of the coating diffuse into the silica matrix of the diffusion tube. Whether or not a metal silicate coating (or metal oxide coating which acts as a precursor for diffusion of the metal ions of the coating into the fused silica matrix of the diffusion tube) remains present on the surface of the diffusion tube depends on the thickness of the applied coating and the amount of heating employed to fuse the metal ions into the silica matrix.

As set forth above, the "metal silicate coating" of the present invention is a glassy region or zone in the outer wall region, the inner wall region, or both the inner wall and the outer wall regions of the fused quartz diffusion tube. The glassy region or zone comprises a silicate of a metal selected from the group consisting of scandium, yttrium, beryllium, rare earth metal or mixture thereof and is preferably continuous and thick enough to reduce sodium infiltration and diffusion from the ambient outside the diffusion tube to the interior of the diffusion tube. The thickness of the zone will generally range between about 2 to about 30 micrometers, but greater thicknesses may be used at the discretion of the practitioner and the conditions under which the diffusion tube is being employed in the manufacture of doped or otherwise treated semiconductor grade silicon metal. Thus, the metal silicate coating of the invention is a glassy region or zone, which can also include a layer of silicate or oxide on the diffusion tube surface in addition to the zone or region within the silica matrix of the diffusion tube (all "coating") comprising a silicate of a metal selected from the group consisting of scandium, yttrium, beryllium, rare earth metal or mixture thereof thick enough to reduce or to prevent diffusion of sodium from the ambient to the interior of the fused quartz diffusion tube.

The metal silicate coating can be applied to either or both wall surfaces of the fused quartz tube as a coating of metal silicate which is then fused onto the wall. Alternately, a coating of metal oxide, or a coating of a metal oxide or metal silicate precursor may be applied and decomposed and fused. Any of several known methods may be employed including coating from a metal alkoxy sol or gel, with thermal conversion to the oxide or silicate; from a suspension of finely divided, metal silicate or oxide in a carrier liquid; from a solution or suspension of a precursor followed by conversion of the precursor into the silicate or oxide; from a powder, frit or slurry of the oxide or silicate, or by chemical vapor deposition (CVD) or low pressure chemical vapor deposition (LPCVD) of a precursor, such as a metal acetyl acetonate, with pyrolytic decomposition of the precursor into the metal oxide. These coatings are then fused into the desired wall portions of the silica tube using, for example, a flame, to form a substantially continuous zone of metal silicate on or within the silica of the wall of the tube.

For example, a precursor, such as scandium or yttrium acetyl acetonate, may be deposited by chemical vapor deposition, atmospheric or low pressure, with pyrolytic decomposition at a temperature of about 300°C, to form a coating of scandium or yttrium oxide, Sc₂O₃ or Yt₂O₃, which is then fused into the silica at a temperature of about 1800°C to form a zone of glassy yttrium or scandium silicate. Alternately, yttrium or scandium or rare earth metal oxide or mixture thereof may be deposited from a suspension thereof, dried, and fused into the silica at a temperature of about 1400-1800°C. The coating may also be applied as a metal silicate powder or frit which is then fused onto and into the desired wall or walls of the fused silica tube.

Thus, if a metal silicate is present on the interior, exterior or both the interior and exterior wall surface of the fused silica tube, whether formed from a suitable silicate precursor or applied as a metal silicate, it is heated to fuse it into a coherent, continuous coating which also fuses it into the wall. Thus, a sharply definable interface between the coating and wall may not exist and continued heating will drive at least a portion into the wall as a zone of metal silicate. Thus, the term "coating" as used herein includes a coating as such, a zone, and combination thereof. If a metal oxide of a metal selected from the group consisting of scandium, yttrium, beryllium, rare earth metal and mixture thereof is applied as an oxide, it is heated at a temperature of about 1800°C to fuse it into the silica arc chamber surface which converts it to the silicate. The term "silicate" as used herein with respect to the coating includes a solution of metal oxide in the silica matrix of the fused silica or quartz diffusion tube wall proximate the surface region thereof. The heating and fusion is easily accomplished by applying a hydrogen-oxygen torch to the exterior surface of the tube while rotating the tube.

The "metal silicate coating", region or zone of the invention was analyzed by X-ray which showed only an amorphous structure, indicating little or no crystalline coating phase present. If the "fused-in" structure was crystalline one would expect distinct X-ray diffraction patterns. The total amount of metal silicate, e.g., scandium silicate, in the glassy region of the fusion tube wall or walls can be determined by dissolving the glass and measuring concentrations by techniques such as inductive coupled plasma spectroscopy. The presence of the metal silicate can also be detected using a scanning electron microscope equipped with an EDX analysis system to produce an EDX dot map of the metal silicate fused into the fused silica wall. Thus, the thickness of the region may be determined from edge fracture surfaces of the region using an EDX dot mapping technique, or any other suitable technique. Typical thicknesses for the region were found to range from 2-30 micrometers.

The invention will be more readily understood by reference to examples below.

### EXAMPLES

### Example 1

Scandium oxide, Sc₂O₃, was applied to a surface of a fused quartz tube by atmospheric chemical vapor deposition and pyrolytic decomposition of a precursor, namely, scandium acetyl acetonate. The scandium oxide coatings so-produced were then fused into the silica to provide a "metal silicate coating" in accordance with the invention by heating the so-coated tubes to a white heat of about 1800°C. These tubes, along with uncoated fused quartz tubes as controls, were then processed into metal halide arc discharge chambers of the type used in lamps disclosed in U.S. Patent 4,918,352. The fills contained a substantial quantity of sodium iodide along with mercury, argon and scandium and thorium iodides. The coated tubes gave substantially improved performance which was related to substantially reduced sodium loss or sodium diffusion through the coated tube. This was determined by operating the lamp for 10,000 hours and measuring free halogen, voltage rise and maintenance of light output which are related to sodium loss in the fill as a result of sodium reaction with the arc tube silica wall and diffusion of the sodium through the wall.

Free halogen was determined by ultraviolet absorption spectroscopy as is well known in the art. Lamps whose fused silica arc tubes were surface-coated with the scandium silicate coating according to the invention had a free halogen level two to four times less than lamps having uncoated arc chambers. The glassy metal silicate coatings of the invention are thus effective for reducing sodium reaction with and diffusion through silica at elevated temperature. When examined by X-ray diffraction, moreover, no crystalline pattern from Sc₂O₃ was observed so that the scandium silicate coatings were amorphous.

### Example 2

A slurry of yttrium silicate (Y₂O₃:SiO₂ in a 28/72 molar ratio) powder prepared by uniformly mixing the powder in a mixture of amyl acetate and ethyl cellulose was applied at the equatorial region to the interior surface of a fused quartz chamber, formed from a tube, which was used for an electrodeless lamp. The coating was uniformly applied to the interior equatorial surface as a 4 mm wide band by rotating the tube or chamber as the slurry was injected into same at the equatorial region. After drying, the coated chambers were then rotated while being heated by a hydrogen-oxygen torch applied to the uncoated, outer surface until the coating became transparent. After this the coated arc tubes were baked in vacuum at 1100°C for 12 hours and both coated and uncoated arc tubes were filled with a mixture of inert gas and sodium and cerium iodides. The chambers were then sealed and radio frequency energy was applied to form an arc discharge in the form of a torus proximate the equatorial region within the chambers. The coldest portion of the chamber during operation of the arc plasma arc discharge was about 900-950°C. After almost 1600 hours of operation of the plasma arc discharge, the chambers having the yttrium silicate coating were analyzed and found to exhibit little sodium diffusion into or through the chamber, as measured by the amount of free iodine released. In marked contrast, after only 750 hours of operation, similar but uncoated chambers having the same fill and having the same toroidal plasma arc discharge energized by radio frequency exhibited more than twice the amount of iodine present as the coated tubes of the invention, which is an indication of more than twice the amount of sodium loss with the uncoated chambers in less than half the time.

## Claims

1. A fused quartz diffusion tube useful in the manufacture of semiconductor elements having an interior surface and an exterior surface with at least one of said surfaces being coated with a metal silicate coating of a metal selected from the group consisting of scandium, yttrium, beryllium, rare earth metal and mixture thereof.

2. A fused quartz diffusion tube of claim 1 wherein said coating is present on the outer surface of said tube.

3. A fused quartz diffusion tube of claim 2 wherein said coating is present only on said outer surface of said tube.

4. A fused quartz diffusion tube of claim 2 wherein said coating is a silicate of a metal selected from the group consisting of scandium, yttrium and mixture thereof.

5. A process for treating semiconductor grade silicon in a fused quartz diffusion tube comprising placing said silicon in said tube, sealing both ends of said tube, introducing a gaseous atmosphere into said tube for treating said silicon and heating said silicon and atmosphere-containing diffusion tube to a temperature sufficient to perform the desired process to said silicon, wherein said diffusion tube has a metal silicate coating of a metal selected from the group consisting of scandium, yttrium, beryllium, rare earth metal and mixture thereof on at least its interior surface or exterior surface or on both its interior and exterior surfaces.

6. A process according to claim 5 wherein said coating is present on the outer surface of said tube.

7. A process according to claim 6 wherein said coating is present only on said outer surface of said tube.

8. A process according to claim 7 wherein said coating is a silicate of a metal selected from the group consisting of scandium, yttrium and mixture thereof.

## Patentansprüche

1. Diffusionsrohr aus geschmolzenem Quarzglas, das bei der Herstellung von Halbleiterbauelementen brauchbar ist, eine innere Oberfläche und eine äußere Oberfläche aufweist, wobei mindestens eine der genannten Oberflächen mit einem Metallsilicat-Überzug eines Metalles überzogen ist, ausgewählt aus der Gruppe bestehend aus Scandium, Yttrium, Beryllium, Seltenerdmetall und einer Mischung davon.

2. Diffusionsrohr aus geschmolzenem Quarzglas nach Anspruch 1, worin der Überzug auf der äußeren Oberfläche des Rohres vorhanden ist.

3. Diffusionsrohr aus geschmolzenem Quarzglas nach Anspruch 2, wobei der Überzug nur auf der äußeren Oberfläche des Rohres vorhanden ist.

4. Diffusionsrohr aus geschmolzenem Quarzglas nach Anspruch 2, worin der Überzug ein Silicat eines Metalles, ausgewählt aus der Gruppe bestehend aus Scandium, Yttrium und einer Mischung davon, ist.

5. Verfahren zum Behandeln von Silicium von Halbleiterqualität in einem Diffusionsrohr aus geschmolzenem Quarzglas, umfassend das Anordnen des Siliciums in dem Rohr, das Abdichten beider Enden des Rohres, das Einführen einer gasförmigen Atmosphäre in das Rohr zur Behandlung des Siliciums und das Erhitzen des Silicium und Atmosphäre enthaltenden Diffusionsrohres auf eine genügende Temperatur, um das erwünschte Verfahren an dem Silicium auszuführen, wobei das Diffusionsrohr auf mindestens seiner inneren oder äußeren Oberfläche oder sowohl auf der inneren und äußeren Oberfläche einen Metallsilicat-Überzug eines Metalles aufweist, das ausgewählt ist aus der Gruppe bestehend aus Scandium, Yttrium, Beryllium, Seltenerdmetall und einer Mischung davon.

6. Verfahren nach Anspruch 5, wobei der Überzug auf der äußeren Oberfläche des Rohres vorhanden ist.

7. Verfahren nach Anspruch 6, wobei der Überzug nur auf der äußeren Oberfläche des Rohres vorhanden ist.

8. Verfahren nach Anspruch 7, worin der Überzug ein Silicat eines Metalles ist, ausgewählt aus der Gruppe bestehend aus Scandium, Yttrium und einer Mischung davon.

## Revendications

1. Tube à diffusion en quartz fondu, utile dans la fabrication des éléments semi-conducteurs, comportant une surface intérieure et une surface extérieure dont l'une au moins est recouverte d'un revêtement de silicate métallique d'un métal choisi dans le groupe formé par le scandium, l'yttrium, le béryllium, les terres rares et un mélange de ceux-ci.

2. Tube à diffusion en quartz fondu selon la revendication 1, dans lequel ledit revêtement est placé sur la surface extérieure dudit tube.

3. Tube à diffusion en quartz fondu selon la revendication 2, dans lequel ledit revêtement n'est présent que sur ladite surface extérieure dudit tube.

4. Tube à diffusion en quartz fondu selon la revendication 2, dans lequel ledit revêtement est un silicate d'un métal choisi dans le groupe formé par le scandium, l'yttrium et un mélange de ceux-ci.

5. Procédé de traitement d'un silicium de qualité composants semi-conducteurs dans un tube à diffusion en quartz fondu, comprenant la mise en place dudit silicium dans ledit tube, la fermeture étanche des deux extrémités dudit tube, l'introduction d'une atmosphère gazeuse dans ledit tube pour traiter ledit silicium et le chauffage dudit silicium et dudit tube à diffusion contenant cette atmosphère à une température suffisante pour réaliser le traitement souhaité pour ledit silicium, dans lequel ledit tube à diffusion comporte un revêtement de silicate métallique d'un métal choisi dans le groupe formé par le scandium, l'yttrium, le béryllium, les terres rares et un mélange de ceux-ci soit sur l'une au moins de ses surfaces intérieure et extérieure soit sur ses deux surfaces intérieure et extérieure.

6. Procédé selon la revendication 5, dans lequel ledit revêtement est placé sur la surface extérieure dudit tube.

7. Procédé selon la revendication 6, dans lequel ledit revêtement n'est présent que sur ladite surface extérieure dudit tube.

8. Procédé selon la revendication 7, dans lequel ledit revêtement est un silicate d'un métal choisi dans le groupe formé par le scandium, l'yttrium et un mélange de ceux-ci.
